# EUROPEAN PATENT SPECIFICATION

(11) **EP 3 364 194 B1**
(45) Date of publication and mention of the grant of the patent: **14.10.2020**
(21) Application number: 15794805.0
(22) Date of filing: 02.11.2015
(51) Int. Cl.: G01R 1/067, G01R 1/073, G01R 3/00

(54) **KELVIN TEST PROBE, KELVIN TEST PROBE MODULE, AND MANUFACTURING METHOD THEREFOR**
KELVIN-TESTSONDE, KELVIN-TESTSONDENMODUL UND HERSTELLUNGSVERFAHREN DAFÜR
SONDE DE TEST DE KELVIN, MODULE DE SONDE DE TEST DE KELVIN, ET LEUR PROCÉDÉ DE FABRICATION

(30) Priority: 08.10.2015 KR 20150141415
(43) Date of publication of application: 22.08.2018
(73) Proprietor: Inno Inc., Gwangju 500-712 (KR)
(72) Inventor: LEE, Eun Jou, Sunwon-si Gyeonggi-do 440-833 (KR)
(74) Representative: Scheele, Friedrich
(86) International application number: PCT/KR2015/011634
(87) International publication number: WO 2017/061656

(56) References cited:
- KR-A- 20090 118 319
- KR-A- 20150 077 762
- KR-A- 20150 077 762
- KR-B1- 101 162 175
- KR-B1- 101 190 174
- KR-B1- 101 489 186
- KR-B1- 101 489 186
- KR-B1- 101 517 409

## Description

### TECHNICAL FIELD

The present invention relates to a probe for Kelvin Test, a probe module for Kelvin Test and a manufacturing method thereof and in particular, to a probe for Kelvin Test, a probe module for Kelvin Test and a manufacturing method thereof which can achieve an easy manufacturing method and save the manufacturing cost.

### BACKGROUND ART

Regarding test of an integrated circuit such as semiconductor, Kevin Test is intended to measure resistance of an integrated circuit element precisely and in general, resistance of integrated circuit is determined by the measurement of electric current and voltage by contacting two contact terminals to an integrated-circuit lead or a ball grid.

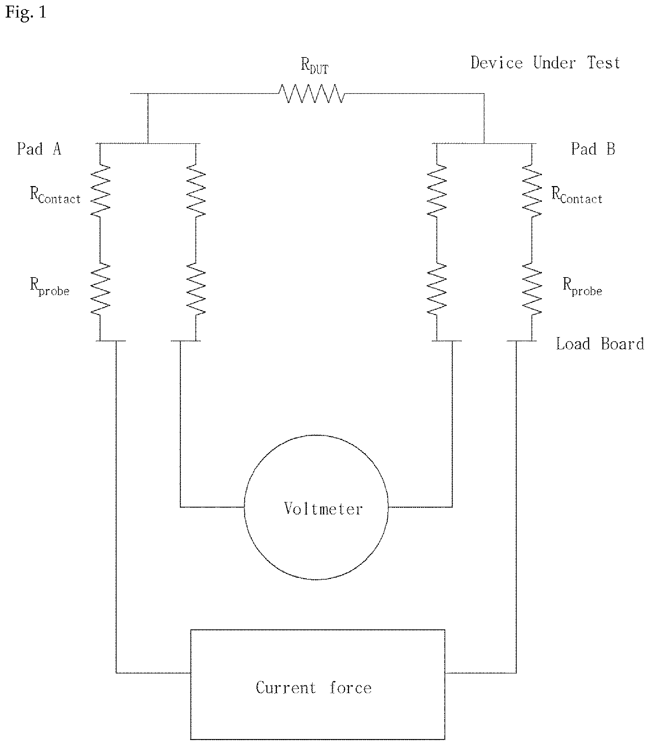

Fig. 1 represents a general concept of Kelvin Test. Referring to Fig. 1, in order to measure resistance of a test element, electric current and voltage are measured by contacting two contact terminals to different points of each of pads (Pad A, Pad B) of a test element.

Such probe for Kelvin Test (or a probe for Kelvin Test) is generally a Pogo-pin type probe and Fig. 2 shows an example of a probe for Kelvin Test disclosed in Korean laid-open patent publication No. 10-2009-0118319.

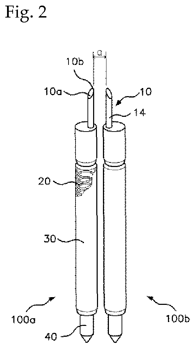

As shown in Fig. 2, a probe for Kelvin Test of prior arts has a pair of probes 100a, 100b which are in parallel and each probe has a plunger 10 which contacts with a contact portion of semiconductor lead, a cylindrical barrel 30 having the plunger 10 on the top, an elastic spring 20 arranged inside the barrel 30 to provide elastic force, and a contact pin 40 attached to the bottom of the barrel 30. That is, a probe for Kelvin Test of a Pogo-pin type is being used which has an elastic force by means of the spring 20.

The above probe for Kelvin Test of prior arts is arranged in a socket (see Fig. 3) for Kelvin Test disclosed in Korean laid-open patent publication No. 10-2011-0132298 and in turn, is applied to a test of a semiconductor element.

However, since the Pogo-pin type probe for Kelvin Test has the structure of a barrel which accommodates the elastic spring and has the structural characteristics of the spring itself, there is limitation to reduce a pitch between the two terminals.

In particular, since the semiconductor elements are becoming more integrated structure and thus the pitch between leads of semiconductor element are reduced to be narrower, recently, the Pogo-pin type probe for Kelvin Test cannot meet the requirement of a high integrated semiconductor element.

Further, since the diameter of the barrel and the size of the spring are reduced due to the high integration of semiconductor element, the insertion of the elastic spring into the barrel is difficult, thereby the manufacturing itself becomes difficult and the manufacturing cost increases as well.

### DISCLOSURE OF THE INVENTION

### Technical Problem

The present invention is invented to solve the above problems and to provide a probe for Kelvin Test, a probe module for Kelvin Test and a manufacturing method thereof which can achieve an easy manufacturing method and save the manufacturing cost.

### Technical Solution

The object of the invention is accomplished by a probe for Kelvin Test according to the invention comprising: an upper insulation sheet made of flexible material; a lower insulation sheet which is spaced apart from the upper insulation sheet in the vertical direction and which is made of flexible material; an insulation elastic member which connects the upper insulation sheet and the lower insulation sheet and which is made of elastic material; a first upper conductive pad which is formed on one surface of the upper insulation sheet; a second upper conductive pad which is formed on the other surface of the upper insulation sheet; a first upper conductive pin which is attached to the first upper conductive pad such that one portion of the first upper conductive pin protrudes above the upper insulation sheet; a second upper conductive pin which is attached to the second upper conductive pad such that one portion of the second upper conductive pin protrudes above the upper insulation sheet; a first lower conductive pad which is formed on one surface of the lower insulation sheet; a second lower conductive pad which is formed on the other surface of the lower insulation sheet; a first lower conductive pin which is attached to the first lower conductive pad such that one portion of the first lower conductive pin protrudes below the lower insulation sheet; a second lower conductive pin which is attached to the second lower conductive pad such that one portion of the second lower conductive pin protrudes below the lower insulation sheet; a first conductive wire which electrically connects the first upper conductive pad and the first lower conductive pad such that the first upper conductive pin, the first upper conductive pad, the first lower conductive pad and the first lower conductive pin form a first conductive line in the vertical direction; and a second conductive wire which electrically connects the second upper conductive pad and the second lower conductive pad such that the second upper conductive pin, the second upper conductive pad, the second lower conductive pad and the second lower conductive pin form a second conductive line in the vertical direction.

Here, the upper insulation sheet and the lower insulation sheet may be provided in the form of a PI film; and the first upper conductive pad, the second upper conductive pad, the first lower conductive pad and the second lower conductive pad may be formed by patterning conductive layers of a flexible circuit substrate having the conductive layers respectively on both surfaces of the PI film.

Also, the first upper conductive pad, the second upper conductive pad, the first lower conductive pad and the second lower conductive pad may be formed by plating base conductive layers which are formed after the conductive layers are patterned.

Further, the insulation elastic member may be made of silicone material.

Further, the probe for Kelvin Test may further comprises an insulation body made of elastic material which surrounds the upper insulation sheet, the lower insulation sheet, the insulation elastic member, the first upper conductive pad, the second upper conductive pad, the first lower conductive pad, the second lower conductive pad, the first conductive wire and the second conductive wire in such a manner that the first upper conductive pin and the second upper conductive pin protrude upwardly and the first lower conductive pin and the second lower conductive pin protrude downwardly.

Meanwhile, the object of the invention may be accomplished by a probe module for Kelvin Test according to another embodiment comprising: an upper insulation sheet made of flexible material; a lower insulation sheet which is spaced apart from the upper insulation sheet in the vertical direction and which is made of flexible material; an insulation elastic member which connects the upper insulation sheet and the lower insulation sheet and which is made of elastic material; a plurality of first upper conductive pads which are spaced apart from each other on one surface of the upper insulation sheet along the surface direction of the sheet; a plurality of second upper conductive pads which are spaced apart from each other on the other surface of the upper insulation sheet along the surface direction of the sheet; first upper conductive pins which are attached respectively to each of the first upper conductive pads such that one portion of each of the first upper conductive pins protrudes above the upper insulation sheet; second upper conductive pins which are attached respectively to each of the second upper conductive pads such that one portion of each of the second upper conductive pins protrudes above the upper insulation sheet; a plurality of first lower conductive pads which are spaced apart from each other on one surface of the lower insulation sheet along the surface direction of the sheet; a plurality of second lower conductive pads which are spaced apart from each other on the other surface of the lower insulation sheet along the surface direction of the sheet; first lower conductive pins which are attached respectively to each of the first lower conductive pads such that one portion of each of the first lower conductive pins protrudes below the lower insulation sheet; second lower conductive pins which are attached respectively to each of the second lower conductive pads such that one portion of each of the second lower conductive pins protrudes below the lower insulation sheet; first conductive wires which electrically connect the first upper conductive pads and the first lower conductive pads which correspond to each other such that the first upper conductive pins, the first upper conductive pads, the first lower conductive pads and the first lower conductive pins which correspond to each other form first conductive lines in the vertical direction; and second conductive wires which electrically connect the second upper conductive pads and the second lower conductive pads which correspond to each other such that the second upper conductive pins, the second upper conductive pads, the second lower conductive pads and the second lower conductive pins which correspond to each other form second conductive lines in the vertical direction.

Here, the upper insulation sheet and the lower insulation sheet may be provided in the form of a PI film; and the first upper conductive pads, the second upper conductive pads, the first lower conductive pads and the second lower conductive pads may be formed by patterning conductive layers of a flexible circuit substrate having the conductive layers respectively on both surfaces of the PI film.

Further, the first upper conductive pads, the second upper conductive pads, the first lower conductive pads and the second lower conductive pads may be formed by plating base conductive layers which are formed after the conductive layers are patterned.

Further, the insulation elastic member may be made of silicone material.

Further, the probe module may further comprise an insulation body made of elastic material which surrounds the upper insulation sheet, the lower insulation sheet, the insulation elastic member, the first upper conductive pads, the second upper conductive pads, the first lower conductive pads, the second lower conductive pads, the first conductive wires and the second conductive wires in such a manner that the first upper conductive pins and the second upper conductive pins protrude upwardly and the first lower conductive pins and the second lower conductive pins protrude downwardly.

Meanwhile, the object of the invention may be accomplished by a method of manufacturing a probe module for Kelvin Test according to another embodiment comprising following steps: (a) forming a plurality of first base conductive pads which are spaced apart from each other on one surface of an insulation sheet made of flexible material along a surface of the sheet and each of which extends from an upper edge to a lower edge; (b) forming a plurality of second base conductive pads which are spaced apart from each other on the other surface of the insulation sheet along a surface of the sheet and each of which extends from an upper edge to a lower edge; (c) attaching first upper conductive pins respectively to an upper edge of each of the first base conductive pads such that one portion of each of the first upper conductive pins protrudes above the insulation sheet; (d) attaching second upper conductive pins respectively to an upper edge of each of the second base conductive pads such that one portion of each of the second upper conductive pins protrudes above the insulation sheet; (e) attaching first lower conductive pins respectively to a lower edge of each of the first base conductive pads such that one portion of each of the first lower conductive pins protrudes below the insulation sheet; (f) attaching second lower conductive pins to a lower edge of each of the second base conductive pads such that one portion of each of the second lower conductive pins protrudes below the insulation sheet; (g) cutting off a boundary between the first upper conductive pins and the first lower conductive pins of the insulation sheet, the first base conductive pads and the second base conductive pads such that the insulation sheet is divided into an upper insulation sheet and a lower insulation sheet, the first base conductive pads are divided into first upper conductive pads and first lower conductive pads, and the second base conductive pads are divided into second upper conductive pads and second lower conductive pads; (h) forming an insulation elastic member by connecting the first upper insulation sheet and the second lower insulation sheet with elastic and insulation material; (i) connecting the first upper conductive pads and the first lower conductive pads which correspond to each other by each of first conductive wires; and (j) connecting the second upper conductive pads and the second lower conductive pads which correspond to each other by each of second conductive wires.

Here, the insulation sheet may be provided in the form of a PI film; and the first base conductive pad and the second base conductive pad may be formed by patterning conductive layers of a flexible circuit substrate having conductive layers respectively on both surfaces of the PI film.

Further, the first base conductive pad and the second base conductive pad may be formed by plating base conductive layers which are formed after the conductive layers are patterned.

Meanwhile, the object of the invention may be accomplished by a method of manufacturing a probe module for Kelvin Test according to another embodiment comprising following steps: (a) forming a plurality of first upper conductive pads which are spaced apart from each other on an upper edge of one surface of an insulation sheet made of flexible material along a surface of the sheet; (b) forming a plurality of second upper conductive pads which are spaced apart from each other on an upper edge of the other surface of the insulation sheet along a surface of the sheet; (c) forming a plurality of first lower conductive pads which are spaced apart from each other on a lower edge of one surface of the insulation sheet along a surface of the sheet; (d) forming a plurality of second lower conductive pads which are spaced apart from each other on a lower edge of the other surface of the insulation sheet along a surface of the sheet; (e) attaching first upper conductive pins respectively to each of the first upper conductive pads such that one portion of each of the first upper conductive pins protrudes above the insulation sheet; (f) attaching second upper conductive pins respectively to each of the second upper conductive pads such that one portion of each of the second upper conductive pins protrudes above the insulation sheet; (g) attaching first lower conductive pins respectively to each of the first lower conductive pads such that one portion of each of the first lower conductive pins protrudes below the insulation sheet; (h) attaching second lower conductive pins respectively to each of the second lower conductive pads such that one portion of each of the second lower conductive pins protrudes below the insulation sheet; (i) cutting off a boundary between the first upper conductive pins and the first lower conductive pins of the insulation sheet such that the insulation sheet is divided into an upper insulation sheet and a lower insulation sheet; (j) forming an insulation elastic member by connecting the upper insulation sheet and the lower insulation sheet with elastic and insulation material; (k) connecting the first upper conductive pads and the first lower conductive pads which correspond to each other by each of first conductive wires; and (1) connecting the second upper conductive pads and the second lower conductive pads which correspond to each other by each of second conductive wires.

Here, the insulation sheet may be provided in the form of a PI film; and the first upper conductive pads, the second upper conductive pads, the first lower conductive pads and the second lower conductive pads may be formed by patterning conductive layers of a flexible circuit substrate having conductive layers on both surfaces of the PI film.

Further, the first upper conductive pads, the second upper conductive pads, the first lower conductive pads and the second lower conductive pads may be formed by plating base conductive layers which are formed after the conductive layers are patterned.

Also, the insulation elastic member may be made of silicone material.

Further, the method may further comprise a step of forming an insulation body made of elastic material which surrounds the upper insulation sheet, the lower insulation sheet, the insulation elastic member, the first upper conductive pads, the second upper conductive pads, the first lower conductive pads, the second lower conductive pads, the first conductive wires and the second conductive wires in such a manner that the first upper conductive pins and the second upper conductive pins protrude upwardly and the first lower conductive pins and the second lower conductive pins protrude downwardly.

### ADVANTAGEOUS EFFECT

According to the present invention, a probe for Kelvin Test, a probe module for Kelvin Test and a manufacturing method thereof which can achieve an easy manufacturing method and save the manufacturing cost is provided.

Also, it can be guaranteed to provide more stable contact by elastic force of the insulation elastic member arranged inside.

### BRIEF DESCRIPTION OF THE DRAWINGS

Fig. 1 represents a general concept of Kelvin Test.
Fig. 2 shows a probe for Kelvin Test of prior art.

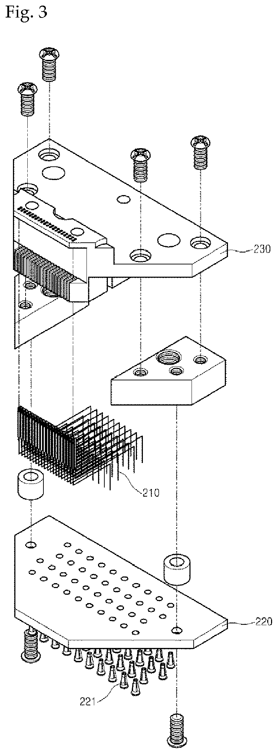

Fig. 3 shows a socket for Kelvin Test of prior art.
Fig. 4 shows a probe for Kelvin Test according to the present invention.
Fig. 5 is a cross-sectional view taken from line V-V of Fig. 5.
Fig. 6 is a perspective view of a probe module for Kelvin Test according to the present invention.
Figs. 7 to 9 represent a method of manufacturing a probe for Kelvin Test according to the present invention.
Fig. 10 is a perspective view of a probe module for Kelvin Test according to another embodiment.
Fig. 11 is a cross-sectional view taken from line XI- XI of Fig. 10.
Fig. 12 represents a method of manufacturing a probe for Kelvin Test according to another embodiment.

### BEST MODE FOR CARRYING OUT THE INVENTION

The invention relates to a probe for Kelvin Test and comprises: an upper insulation sheet made of flexible material; a lower insulation sheet which is spaced apart from the upper insulation sheet in the vertical direction and which is made of flexible material; an insulation elastic member which connects the upper insulation sheet and the lower insulation sheet and which is made of elastic material; a first upper conductive pad which is formed on one surface of the upper insulation sheet; a second upper conductive pad which is formed on the other surface of the upper insulation sheet; a first upper conductive pin which is attached to the first upper conductive pad such that one portion of the first upper conductive pin protrudes above the upper insulation sheet; a second upper conductive pin which is attached to the second upper conductive pad such that one portion of the second upper conductive pin protrudes above the upper insulation sheet; a first lower conductive pad which is formed on one surface of the lower insulation sheet; a second lower conductive pad which is formed on the other surface of the lower insulation sheet; a first lower conductive pin which is attached to the first lower conductive pad such that one portion of the first lower conductive pin protrudes below the lower insulation sheet; a second lower conductive pin which is attached to the second lower conductive pad such that one portion of the second lower conductive pin protrudes below the lower insulation sheet; a first conductive wire which electrically connects the first upper conductive pad and the first lower conductive pad such that the first upper conductive pin, the first upper conductive pad, the first lower conductive pad and the first lower conductive pin form a first conductive line in the vertical direction; and a second conductive wire which electrically connects the second upper conductive pad and the second lower conductive pad such that the second upper conductive pin, the second upper conductive pad, the second lower conductive pad and the second lower conductive pin form a second conductive line in the vertical direction.

### MODE FOR CARRYING OUT THE INVENTION

Hereinafter, preferred embodiments according to the present invention will be explained in detail referring to attached drawings.

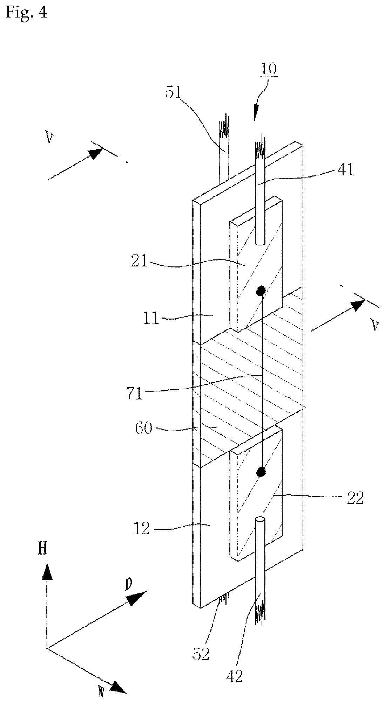

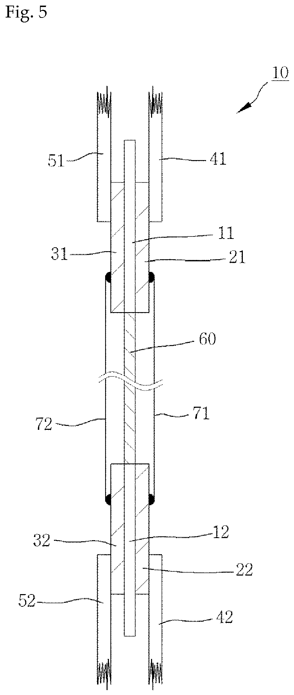

Fig. 4 is a perspective view of a probe 10 of Kelvin Test according to the present invention and Fig. 5 is a cross-sectional view taken from line V-V of Fig. 5. Referring to Figs. 4 and 5, the probe 10 of Kelvin Test according to the present invention comprises an upper insulation sheet 11, a lower insulation sheet 12, an insulation elastic member 60, a first upper conductive pad 21, a second upper conductive pad 31, a first upper conductive pin 41, a second upper conductive pin 51, a first lower conductive pad 22, a second lower conductive pad 32, a first lower conductive pin 42, a second lower conductive pin 52, a first conductive wire 71 and a second conductive wire 72.

The upper insulation sheet 11 is made of flexible material. In one example, the upper insulation sheet 11 is made of PI film material and will be explained in detail hereinafter.

Similarly, the lower insulation sheet 12 is made of flexible material. In one example, the lower insulation sheet 12 is made in the form of PI film in the same manner as the upper insulation sheet 11. Here, the lower insulation sheet 12 is spaced apart from the upper insulation sheet 11 in the vertical direction H as shown in Figs. 4 and 5.

The insulation elastic member 60 is made of elastic material, e.g., silicone material to connect the upper insulation sheet 11 and the lower insulation sheet 12 which are spaced apart in the vertical direction H.

Here, the upper insulation sheet 11, the insulation elastic member 60 and the lower insulation sheet 12 electrically separate a first conductive line and a second conductive line which are formed respectively on both sheet surfaces which will be explained hereinafter.

The first upper conductive pad 21 is formed on one surface of the upper insulation sheet 11. The second upper conductive pad 31 is formed on the other surface of the upper insulation sheet 11. That is, the first upper conductive pad 21 and the second upper conductive pad 31 have the upper insulation sheet 11 therebetween and are arranged on both sides of the upper insulation sheet 11 such that they are electrically separated from each other by the upper insulation sheet 11.

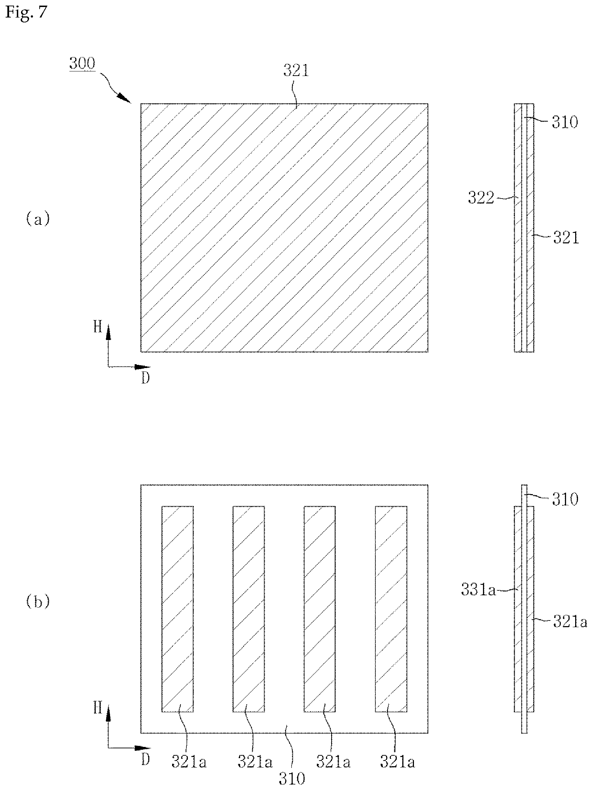

Here, as explained above, the upper insulation sheet 11 is provided in the form of PI film and the first upper conductive pad 21 and the second upper conductive pad 31 are formed by patterning conductive layers 321, 322 of a flexible circuit substrate 300 (see Fig. 7) which have the conductive layers 321, 322 on the both sides of the PI film, which will be explained in detail hereinafter.

The first lower conductive pad 22 is formed on one side of the lower insulation sheet 12. The second lower conductive pad 32 is formed on the other surface of the lower insulation sheet 12. That is, the first lower conductive pad 22 and the second lower conductive pad 32 have the lower insulation sheet 12 therebetween and are arranged on both sides of the lower insulation sheet 12 and are electrically separated from each other by the lower insulation sheet 12.

Here, as explained above, the lower insulation sheet 12 is provided in the form of PI film and the first lower conductive pad 22 and the second lower conductive pad 32 are formed by patterning conductive layers 321, 322 of a flexible circuit substrate 300 (see Fig. 7) which have the conductive layers 321, 322 on the both sides of the PI film, which will be explained in detail hereinafter.

The first upper conductive pin 41 is attached on the first upper conductive pad 21 such that one portion of the first upper conductive pin, i.e., the top portion of the first upper conductive pin protrudes above the upper insulation sheet 11. Similarly, the second upper conductive pin 51 is attached on the second upper conductive pad 31 such that one portion of the second upper conductive pin, i.e., the top portion of the second upper conductive pin protrudes above the upper insulation sheet 11. Here, the first upper conductive pin 41 and the second upper conductive pin 51 are spaced apart from each other by the thickness of the upper insulation sheet 11, the first upper conductive pad 21 and the second upper conductive pad 31.

The first lower conductive pin 42 is attached on the first lower conductive pad 22 such that one portion of the first lower conductive pin, i.e., the bottom portion of the first lower conductive pin protrudes below the lower insulation sheet 12. Similarly, the second lower conductive pin 52 is attached on the second lower conductive pad 32 such that one portion of the second lower conductive pin, i.e., the bottom portion of the second lower conductive pin protrudes below the lower insulation sheet 12. Here, the first lower conductive pin 42 and the second lower conductive pin 52 are spaced apart from each other by the thickness of the lower insulation sheet 12, the first lower conductive pad 22 and the second lower conductive pad 32.

The first conductive wire 71 electrically connects the first upper conductive pad 21 to the first lower conductive pad 22. Therefore, the first upper conductive pin 41, the first upper conductive pad 21, the first conductive wire 71, the first lower conductive pad 22 and the first lower conductive pin 42 are electrically interconnected to form a first conductive line in the vertical direction H.

Similarly, the second conductive wire 72 electrically connects the second upper conductive pad 31 to the second lower conductive pad 32 such that the second upper conductive pin 51, the second upper conductive pad 31, the second conductive wire 72, the second lower conductive pad 32 and the second lower conductive pin 52 are electrically interconnected to form a second conductive line in the vertical direction H.

According to the above arrangement, a probe 10 for Kelvin Test is provided which has the first conductive line and the second conductive line which have the upper insulation sheet 11, the lower insulation sheet 12 and the insulation elastic member 62 therebetween. The gap between the two conductive lines can be reduced to the sum of the thickness of the insulation sheet 310, the first upper conductive pad 21 (or the first lower conductive pad 22) and the second upper conductive pad 31 (or the second lower conductive pad 32), so that it is possible to perform a Kelvin Test for a high-integrated semiconductor element.

Also, since the first upper conductive pad 21, the second upper conductive pad 31, the first lower conductive pad 22 and the second lower conductive pad 32 can be manufactured by the patterning process of the flexible circuit substrate 300, the more effective manufacturing method and in turn the reduction of the manufacturing cost can be obtained.

Hereinafter, preferred embodiments according to the present invention will be explained in detail referring to attached drawings.

Fig. 4 is a perspective view of a probe 10 of Kelvin Test according to the present invention and Fig. 5 is a cross-sectional view taken from line V-V of Fig. 5. Referring to Figs. 4 and 5, the probe 10 of Kelvin Test according to the present invention comprises an upper insulation sheet 11, a lower insulation sheet 12, an insulation elastic member 60, a first upper conductive pad 21, a second upper conductive pad 31, a first upper conductive pin 41, a second upper conductive pin 51, a first lower conductive pad 22, a second lower conductive pad 32, a first lower conductive pin 42, a second lower conductive pin 52, a first conductive wire 71 and a second conductive wire 72.

The upper insulation sheet 11 is made of flexible material. In one example, the upper insulation sheet 11 is made of PI film material and will be explained in detail hereinafter.

Similarly, the lower insulation sheet 12 is made of flexible material. In one example, the lower insulation sheet 12 is made in the form of PI film in the same manner as the upper insulation sheet 11. Here, the lower insulation sheet 12 is spaced apart from the upper insulation sheet 11 in the vertical direction H as shown in Figs. 4 and 5.

The insulation elastic member 60 is made of elastic material, e.g., silicone material to connect the upper insulation sheet 11 and the lower insulation sheet 12 which are spaced apart in the vertical direction H.

Here, the upper insulation sheet 11, the insulation elastic member 60 and the lower insulation sheet 12 electrically separate a first conductive line and a second conductive line which are formed respectively on both sheet surfaces which will be explained hereinafter.

The first upper conductive pad 21 is formed on one surface of the upper insulation sheet 11. The second upper conductive pad 31 is formed on the other surface of the upper insulation sheet 11. That is, the first upper conductive pad 21 and the second upper conductive pad 31 have the upper insulation sheet 11 therebetween and are arranged on both sides of the upper insulation sheet 11 such that they are electrically separated from each other by the upper insulation sheet 11.

Here, as explained above, the upper insulation sheet 11 is provided in the form of PI film and the first upper conductive pad 21 and the second upper conductive pad 31 are formed by patterning conductive layers 321, 322 of a flexible circuit substrate 300 (see Fig. 7) which have the conductive layers 321, 322 on the both sides of the PI film, which will be explained in detail hereinafter.

The first lower conductive pad 22 is formed on one side of the lower insulation sheet 12. The second lower conductive pad 32 is formed on the other surface of the lower insulation sheet 12. That is, the first lower conductive pad 22 and the second lower conductive pad 32 have the lower insulation sheet 12 therebetween and are arranged on both sides of the lower insulation sheet 12 and are electrically separated from each other by the lower insulation sheet 12.

Here, as explained above, the lower insulation sheet 12 is provided in the form of PI film and the first lower conductive pad 22 and the second lower conductive pad 32 are formed by patterning conductive layers 321, 322 of a flexible circuit substrate 300 (see Fig. 7) which have the conductive layers 321, 322 on the both sides of the PI film, which will be explained in detail hereinafter.

The first upper conductive pin 41 is attached on the first upper conductive pad 21 such that one portion of the first upper conductive pin, i.e., the top portion of the first upper conductive pin protrudes above the upper insulation sheet 11. Similarly, the second upper conductive pin 51 is attached on the second upper conductive pad 31 such that one portion of the second upper conductive pin, i.e., the top portion of the second upper conductive pin protrudes above the upper insulation sheet 11. Here, the first upper conductive pin 41 and the second upper conductive pin 51 are spaced apart from each other by the thickness of the upper insulation sheet 11, the first upper conductive pad 21 and the second upper conductive pad 31.

The first lower conductive pin 42 is attached on the first lower conductive pad 22 such that one portion of the first lower conductive pin, i.e., the bottom portion of the first lower conductive pin protrudes below the lower insulation sheet 12. Similarly, the second lower conductive pin 52 is attached on the second lower conductive pad 32 such that one portion of the second lower conductive pin, i.e., the bottom portion of the second lower conductive pin protrudes below the lower insulation sheet 12. Here, the first lower conductive pin 42 and the second lower conductive pin 52 are spaced apart from each other by the thickness of the lower insulation sheet 12, the first lower conductive pad 22 and the second lower conductive pad 32.

The first conductive wire 71 electrically connects the first upper conductive pad 21 to the first lower conductive pad 22. Therefore, the first upper conductive pin 41, the first upper conductive pad 21, the first conductive wire 71, the first lower conductive pad 22 and the first lower conductive pin 42 are electrically interconnected to form a first conductive line in the vertical direction H.

Similarly, the second conductive wire 72 electrically connects the second upper conductive pad 31 to the second lower conductive pad 32 such that the second upper conductive pin 51, the second upper conductive pad 31, the second conductive wire 72, the second lower conductive pad 32 and the second lower conductive pin 52 are electrically interconnected to form a second conductive line in the vertical direction H.

According to the above arrangement, a probe 10 for Kelvin Test is provided which has the first conductive line and the second conductive line which have the upper insulation sheet 11, the lower insulation sheet 12 and the insulation elastic member 62 therebetween. The gap between the two conductive lines can be reduced to the sum of the thickness of the insulation sheet 310, the first upper conductive pad 21 (or the first lower conductive pad 22) and the second upper conductive pad 31 (or the second lower conductive pad 32), so that it is possible to perform a Kelvin Test for a high-integrated semiconductor element.

Also, since the first upper conductive pad 21, the second upper conductive pad 31, the first lower conductive pad 22 and the second lower conductive pad 32 can be manufactured by the patterning process of the flexible circuit substrate 300, the more effective manufacturing method and in turn the reduction of the manufacturing cost can be obtained.

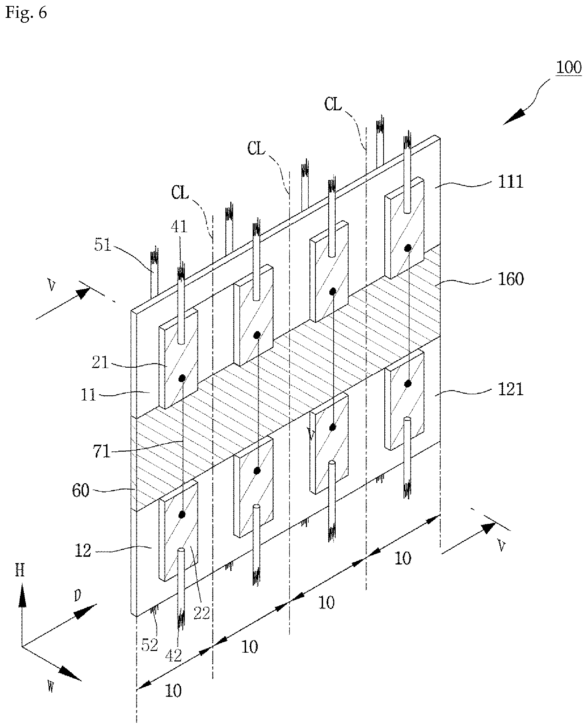

Meanwhile, Fig. 6 is a perspective view of a probe module 100 for Kelvin Test according to the present invention. Referring to Fig. 6, the probe module 100 for Kelvin Test according to the present invention has a plurality of probes 10 along the direction D of the surface of the upper insulation sheet 11 (or the lower insulation sheet 12). Here, the cross-section of Fig. 6 taken from V-V line is the same as the cross-sectional view of Fig. 5 and thus, the cross-sectional shape as to the probe module 100 for Kelvin Test according to the present invention will be explained referring to Fig. 5.

In detail, the probe module 100 for Kelvin Test according to the present invention comprises an upper insulation sheet 11, a lower insulation sheet 12, an insulation elastic member 60, a plurality of first upper conductive pads 21, a plurality of second upper conductive pads 31, a plurality of first upper conductive pins 41, a plurality of second upper conductive pins 51, a plurality of first lower conductive pads 22, a plurality of second lower conductive pads 32, a plurality of first lower conductive pins 42, a plurality of second lower conductive pins 52, a plurality of first conductive wires 71 and a plurality of second conductive wires 72.

Similarly to the upper insulation sheet 11 of the probe 10 for Kelvin Test, the upper insulation sheet 11 is made of flexible material and in one example, it can be made of PI film material.

The lower insulation sheet 12 is made of flexible material. In one example, the lower insulation sheet 12 is made in the form of PI film, like the upper insulation sheet 11. Here, the lower insulation sheet 12 is spaced apart from the upper insulation sheet 11 in the vertical direction H as shown in Fig. 6.

The insulation elastic member 60 is made of elastic material, e.g., silicone material to connect the upper insulation sheet 11 and the lower insulation sheet 12 which are spaced apart in the vertical direction H. Here, the upper insulation sheet 11, the insulation elastic member 60 and the lower insulation sheet 12 electrically separate a plurality of first conductive lines and a plurality of second conductive lines which are formed respectively on both sheet surfaces which will be explained hereinafter.

The plurality of first upper conductive pads 21 are formed on one surface of the upper insulation sheet 11 and as shown in Fig. 6, the first upper pads are spaced apart from each other on the surface of the upper insulation sheet along the sheet surface direction D.

The plurality of second upper conductive pads 31 are formed on the other surface of the upper insulation sheet 11 and are spaced apart from each other along the sheet surface direction D. Here, the first upper conductive pad 21 and the second upper conductive pad 31 which correspond to each other face each other across the upper insulation sheet 11.

Here, the plurality of first upper conductive pads 21 and the plurality of second upper conductive pads 31 have the upper insulation sheet 11 therebetween and are arranged on both sides of the upper insulation sheet 11 such that they are electrically separated from each other by the upper insulation sheet 11.

Here, as explained above, the upper insulation sheet 11 is provided in the form of PI film and the upper conductive pad 21 and the second upper conductive pad 31 are formed by patterning conductive layers 321, 322 of a flexible circuit substrate 300 (see Fig. 7) which have the conductive layers 321, 322 on the both sides of the PI film, which will be explained in detail hereinafter.

The plurality of first lower conductive pads 22 are formed on one side of the lower insulation sheet 12 and are spaced apart from each other along the surface direction D of the lower insulation sheet 12. Similarly, the plurality of second lower conductive pads 32 are formed on the other side of the lower insulation sheet 12 and are spaced apart from each other along the surface direction D of the lower insulation sheet 12. Here, the first lower conductive pad 22 and the second lower conductive pad 32 which correspond to each other face each other across the lower insulation sheet 12.

Further, the first upper conductive pad 21 and the first lower conductive pad 22 which correspond to each other are arranged to face each other in the vertical direction H and the second upper conductive pad 31 and the second lower conductive pad 32 which correspond to each other are arranged to face each other in the vertical direction H.

Also, as explained above, the lower insulation sheet 12 is provided in the form of PI film and the lower conductive pad 22 and the second lower conductive pad 32 are formed by patterning conductive layers 321, 322 of a flexible circuit substrate 300 (see Fig. 7) which have the conductive layers 321, 322 on the both sides of the PI film.

Also, a first upper conductive pin 41 is attached on each of the first upper conductive pads 21 such that one portion of the first upper conductive pin 41 protrudes above the upper insulation sheet 11. Similarly, a second upper conductive pin 51 is attached on each of the second upper conductive pads 31 such that one portion of the second upper conductive pin 51 protrudes above the upper insulation sheet 11.

A first lower conductive pin 42 is attached on each of the first lower conductive pads 22 such that one portion of the first lower conductive pin 42 protrudes below the lower insulation sheet 12. Similarly, a second lower conductive pin 52 is attached on each of the second lower conductive pads 32 such that one portion of the second lower conductive pin 52 protrudes below the lower insulation sheet 12.

The first upper conductive pad 21 and the first lower conductive pad 22 which face each other in the vertical direction H are electrically connected to each other by a first conductive wire 71. Similarly, the second upper conductive pad 31 and the second lower conductive pad 32 which face each other in the vertical direction H are electrically connected to each other by a second conductive wire 72.

With the above arrangement, the plurality of first conductive lines each of which is formed in the vertical direction D are arranged along the surface direction D in such a manner that the upper insulation sheet 11, the insulation elastic member 60 and the lower insulation sheet 12 are arranged between the first conductive lines and the second conductive lines and that the first upper conductive pin 41, the first upper conductive pad 21, the first conductive wire 71, the first lower conductive pad 22 and the first lower conductive pin 42 are interconnected on one side.

Further, the plurality of second conductive lines each of which is formed in the vertical direction D are arranged along the surface direction D in such a manner that the upper insulation sheet 11, the insulation elastic member 60 and the lower insulation sheet 12 are arranged between the first conductive lines and the second conductive lines and that the second upper conductive pin 51, the second upper conductive pad 31, the second conductive wire 72, the second lower conductive pad 32 and the second lower conductive pin 52 are interconnected on the other side.

Here, the first conductive line and the second conductive line which have the upper insulation sheet 11, the insulation elastic member 60 and the lower insulation sheet 12 therebetween are configured to form one probe 10 for Kelvin Test and thus the plurality of probes 10 for Kelvin Test can be arranged along the direction D of the sheet surface.

Here, if the probe module 100 for Kelvin Test is taken along the dotted line of Fig. 6, one probe 10 for Kelvin Test of Fig. 4 can be obtained.

Hereinafter, referring to Figs. 7 to 9, a method of manufacturing a probe module 100 for Kelvin Test according to the present invention will be described in detail.

First, a plurality of first base conductive pad 321a is formed on one side of the insulation sheet 310 and a plurality of second base conductive pad 331a is formed on the other side of the insulation sheet. In one example, as explained above, a flexible circuit substrate 300 is used having conductive layers 321, 322 on both surfaces of PI film as shown in Fig. 7(a).

As shown in Fig. 7(a), a flexible circuit substrate 300 is prepared having conductive layers 321, 322 on both surfaces of the insulation sheet 310 which is PI film-type. Then, using a mask having a pattern which corresponds to the first base conductive pad 321a, a plurality of first base conductive pads 321a are formed on one side of the insulation sheet 310 as shown in Fig. 7(b) by a process of etching or photolithography. Similarly, using a mask having a pattern which corresponds to the second base conductive pad 331a, a plurality of second base conductive pads 331a are formed on the other side of the insulation sheet 310.

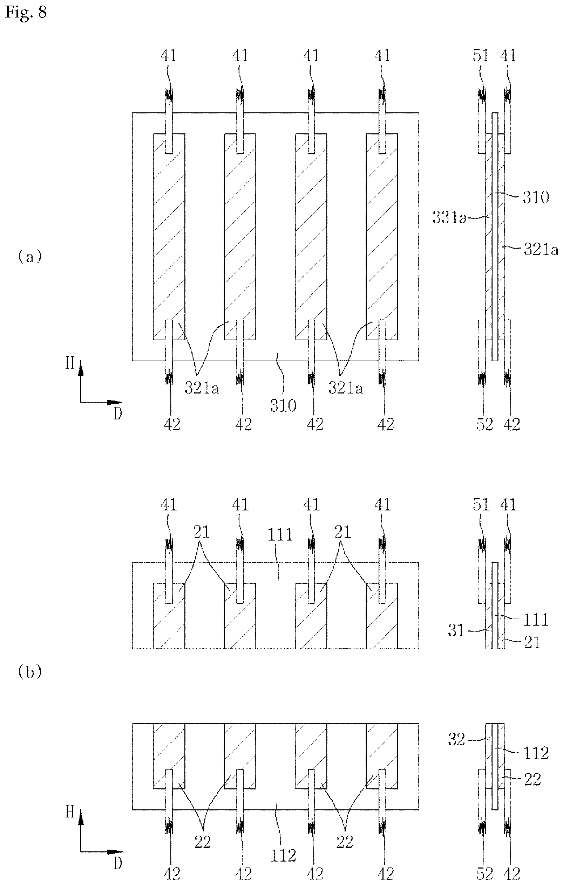

Then, as shown in Fig. 8(a), a first upper conductive pin 41 is attached to the upper edge of each of the first base conductive pad 321a and a second upper conductive pin 51 is attached to the upper edge of each of the second base conductive pad 331a. Here, the first upper conductive pin 41 and the second upper conductive pin 51 are attached such that one portion of the pin protrudes above the insulation sheet 310.

Similarly, a first lower conductive pin 42 is attached to the lower edge of each of the first base conductive pad 321a and a second lower conductive pin 52 is attached to the lower edge of each of the second base conductive pad 331a. Here, the first lower conductive pin 42 and the second lower conductive pin 52 are attached such that one portion of the pin protrudes below the insulation sheet 310.

Then, as shown in Fig. 8(b), a predetermined portion between the first upper conductive pin 41 and the first lower conductive pin 42 (or between the second upper conductive pin 51 and the second lower conductive pin 52) is cut off. With the cut-off, the insulation sheet 310 is divided into the upper insulation sheet 11 and the lower insulation sheet 12, the first base conductive pad 321a is divided into the first upper conductive pad 21 and the first lower conductive pad 22, and the second base conductive pad 331a is divided into the second upper conductive pad 31 and the second lower conductive pad 32.

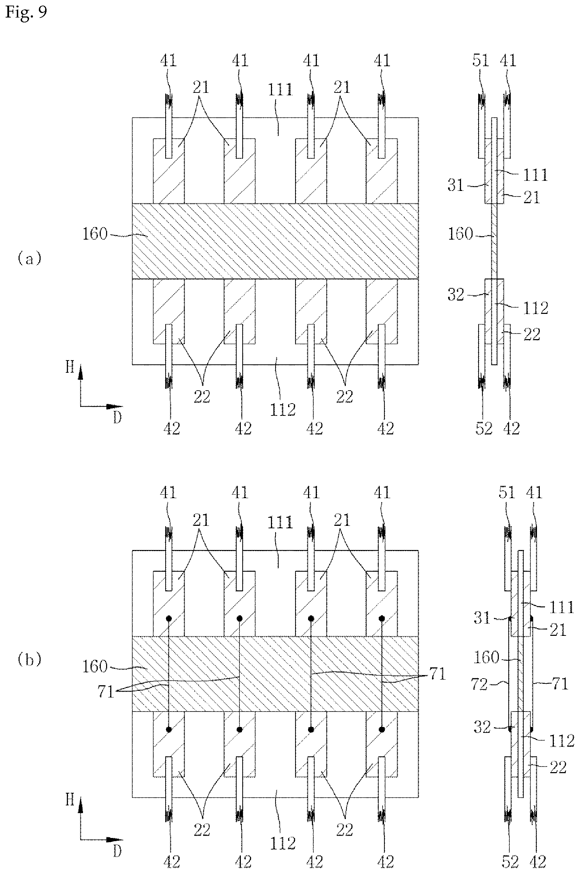

After the above process, a process is proceeded to form an insulation elastic member 60 on the cut-off area between the upper insulation sheet 11 and the lower insulation sheet 12. As shown in Fig. 9(a), a liquid silicone is applied to an area between the upper insulation sheet 11 and the lower insulation sheet 12, and then is cured to form the insulation elastic member 60.

The embodiment shows that the insulation elastic member 60 corresponds to the boundary line of the bottom of the upper insulation sheet 11 and the boundary line of the top of the lower insulation sheet 12. Alternatively, during application of silicone, silicone can be applied to cover the bottom of the upper insulation sheet 11 and the top of the lower insulation sheet 12 and then be cured.

After the insulation elastic member 60 is formed, the first upper conductive pad 21 and the first lower conductive pad 22 which face each other in the vertical direction H are connected to each other by the first conductive wire 71 and the second upper conductive pad 31 and the second lower conductive pad 32 which face each other in the vertical direction H are connected to each other by the second conductive wire 72 as shown in Fig. 9(b). Here, the first conductive wire 71 and the second conductive wire 72 can be connected to the first upper conductive pad 21, the first lower conductive pad 22, the second upper conductive pad 31 and the second lower conductive pad 32, respectively by soldering.

With the above process, a probe module 100 for Kelvin Test according to the present invention is manufactured.

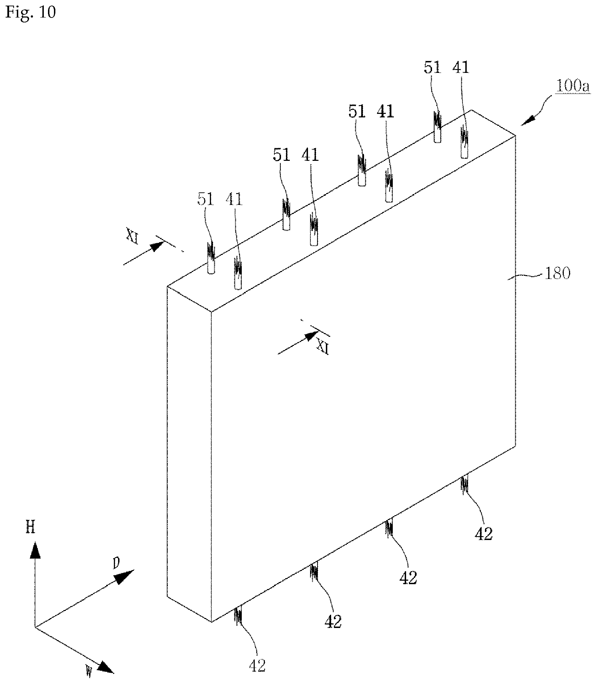

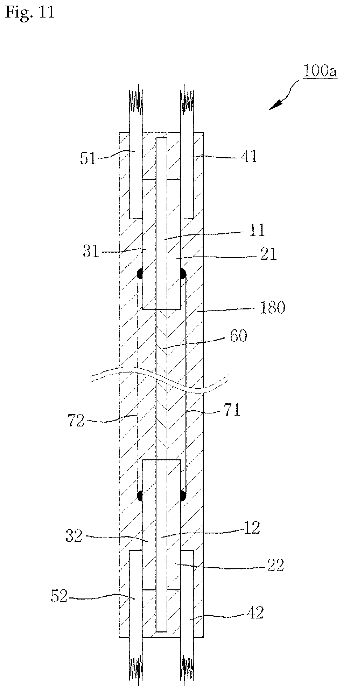

Meanwhile, Figs. 10 and 11 describe a probe module 100a for Kelvin Test according to another embodiment of the present invention. Fig. 10 is a perspective view of a probe module for Kelvin Test according to another embodiment and Fig. 11 is a cross-sectional view taken from line XI- XI of Fig. 10.

The probe module 100a for Kelvin Test shown in Figs. 10 and 11 is a modified embodiment of the probe module 100 explained in the above. In one example, the outer part of the probe module 100 for Kelvin Test is surrounded by an elastic insulation body 180. That is, the first upper conductive pin 41 and the second upper conductive pin 51 protrude upwardly and the first lower conductive pin 42 and the second lower conductive pin 52 protrude downwardly such that the upper insulation sheet 11, the lower insulation sheet 12, the insulation elastic member 60, the first upper conductive pad 21, the second upper conductive pad 31, the first lower conductive pad 22, the second lower conductive pad 32, the first conductive wire 71 and the second conductive wire 72 are surrounded by the insulation body 180.

Therefore, when the probe module 100a for Kelvin Test is attached in the depth direction W depending on the shape of the terminal formed on the semiconductor element, it is possible to attach the probe module to the terminal without any further housing for electrical insulation. Alternatively, in case of using a separate housing for the insulation, the probe module 100 for Kelvin Test as shown in Fig. 6 can be used.

Meanwhile, in the example explained in the above, as shown in Fig. 8(a) and Fig. 8(b), after the first base conductive pad 321a and the second base conductive pad 331a are formed on the insulation sheet 310, the first upper conductive pad 21, the second upper conductive pad 31, the first lower conductive pad 22 and the second lower conductive pad 32 are formed by the cut-off.

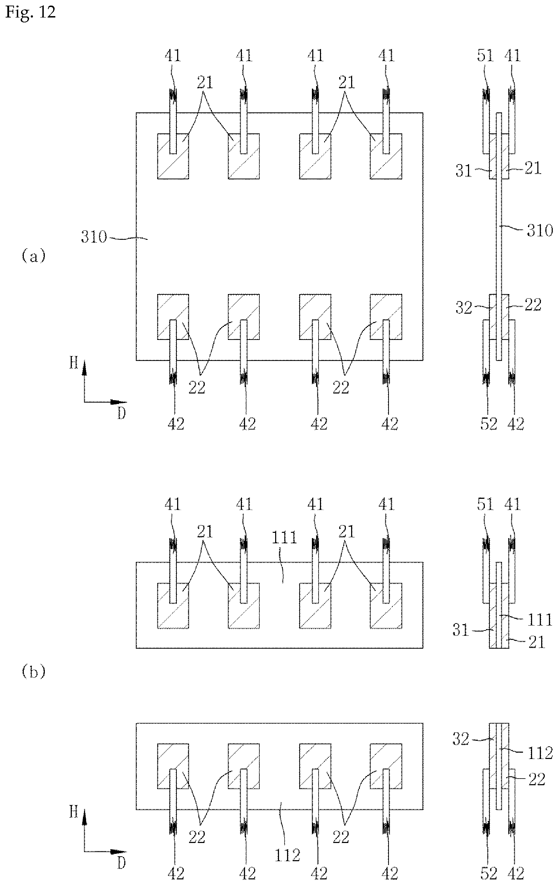

Fig. 12 represents another embodiment in which during patterning a flexible circuit substrate 300, the first upper conductive pad 21, the second upper conductive pad 31, the first lower conductive pad 22 and the second lower conductive pad 32 are formed on the insulation sheet 310 in the form of a PI film as shown in Fig. 12, and the first upper conductive pin 41, the second upper conductive pin 51, the first lower conductive pin 42 and the second lower conductive pin 52 are attached, respectively. Then, as shown in Fig. 12(b), the upper insulation sheet 11 and the lower insulation sheet 12 can be also separated by the cut-off of the insulation sheet 310.

Meanwhile, in the above examples, the first base conductive pad 321a, the second base conductive pad 331a, the first upper conductive pad 21, the second upper conductive pad 31, the first lower conductive pad 22 and the second lower conductive pad 32 can be formed by the plating, e.g., by nickel plating and then gold plating, of the base conductive layers 321, 322 formed by the patterning of PI film.

**<List of reference numerals>**

| | |
|---|---|
| 1: probe for Kelvin Test | 11: upper insulation sheet |
| 12: lower insulation sheet | 21: first upper conductive pad |
| 22: first lower conductive pad | 31: second upper conductive pad |
| 32: second lower conductive pad | 41: first upper conductive pin |
| 42: first lower conductive pin | 51: second upper conductive pin |
| 52: second lower conductive pin | 60: insulation elastic member |
| 71: first conductive wire | 72: second conductive wire |
| 100: probe module for Kelvin Test | 111: upper insulation sheet |
| 121: lower insulation sheet | 160: insulation elastic member |

### INDUSTRIAL APPLICABILITY

The present invention can be used for the test of integrated circuit such as semiconductor, in particular Kelvin Test, to measure resistance of integrated circuit precisely.

## Claims

1. A probe (10) for Kelvin Test comprising:
an upper insulation sheet (11) made of flexible material;
a lower insulation sheet (12) which is spaced apart from the upper insulation sheet (11) in the vertical direction and which is made of flexible material;
an insulation elastic member (60) which connects the upper insulation sheet (11) and the lower insulation sheet (12) and which is made of elastic material;
a first upper conductive pad (21) which is formed on one surface of the upper insulation sheet (11);
a second upper conductive pad (31) which is formed on the other surface of the upper insulation sheet (11);
a first upper conductive pin (41) which is attached to the first upper conductive pad (21) such that one portion of the first upper conductive pin (41) protrudes above the upper insulation sheet (11);
a second upper conductive pin (51) which is attached to the second upper conductive pad (31) such that one portion of the second upper conductive pin (51) protrudes above the upper insulation sheet (11);
a first lower conductive pad (22) which is formed on one surface of the lower insulation sheet (12);
a second lower conductive pad (32) which is formed on the other surface of the lower insulation sheet (12);
a first lower conductive pin (42) which is attached to the first lower conductive pad (22) such that one portion of the first lower conductive pin (42) protrudes below the lower insulation sheet (12);
a second lower conductive pin (52) which is attached to the second lower conductive pad (32) such that one portion of the second lower conductive pin (52) protrudes below the lower insulation sheet (12);
a first conductive wire (71) which electrically connects the first upper conductive pad (21) and the first lower conductive pad (22) such that the first upper conductive pin (41), the first upper conductive pad (21), the first lower conductive pad (22) and the first lower conductive pin (42) form a first conductive line in the vertical direction; and
a second conductive wire (72) which electrically connects the second upper conductive pad (31) and the second lower conductive pad (32) such that the second upper conductive pin (51), the second upper conductive pad (31), the second lower conductive pad (32) and the second lower conductive pin (52) form a second conductive line in the vertical direction.

2. The probe (10) for Kelvin Test according to Claim 1,
wherein the upper insulation sheet (11) and the lower insulation sheet (12) are provided in the form of a PI film; and
wherein the first upper conductive pad (21), the second upper conductive pad (31), the first lower conductive pad (22) and the second lower conductive pad (32) are formed by patterning conductive layers of a flexible circuit substrate having the conductive layers respectively on both surfaces of the PI film.

3. The probe (10) for Kelvin Test according to Claim 2,
wherein the first upper conductive pad (21), the second upper conductive pad (31), the first lower conductive pad (22) and the second lower conductive pad (32) are formed by plating base conductive layers which are formed after the conductive layers are patterned.

4. The probe (10) for Kelvin Test according to Claim 1,
wherein the insulation elastic member (60) is made of silicone material.

5. The probe (10) for Kelvin Test according to Claim 1,
further comprising an insulation body (180) made of elastic material which surrounds the upper insulation sheet (11), the lower insulation ; sheet (12), the insulation elastic member (60), the first upper conductive pad (21), the second upper conductive pad (31), the first lower conductive pad (22), the second lower conductive pad (32), the first conductive wire (71) and the second conductive wire : (72) in such a manner that the first upper conductive pin (41) and the second upper conductive pin (51) protrude upwardly and the first lower conductive pin (42) and the second lower conductive pin (52) protrude downwardly.

6. A probe module (100) for Kelvin Test comprising:
an upper insulation sheet (11, 111) made of flexible material;
a lower insulation sheet (12, 112) which is spaced apart from the upper insulation sheet (11, 111) in the vertical direction and which is made of flexible material;
an insulation elastic member (60, 160) which connects the upper insulation sheet (11, 111) and the lower insulation sheet (12, 112) and which is made of elastic material;
a plurality of first upper conductive pads (21) which are spaced apart from each other on one surface of the upper insulation sheet (11, 111) along the surface direction of the sheet;
a plurality of second upper conductive pads (31) which are spaced apart from each other on the other surface of the upper insulation sheet (11, 111) along the surface direction of the sheet;
first upper conductive pins (41) which are attached respectively to each of the first upper conductive pads (21) such that one portion of each of the first upper conductive pins (41) protrudes above the upper insulation sheet (11, 111);
second upper conductive pins (51) which are attached respectively to each of the second upper conductive pads (31) such that one portion of each of the second upper conductive pins (51) protrudes above the upper insulation sheet (11, 111);
a plurality of first lower conductive pads (22) which are spaced apart from each other on one surface of the lower insulation sheet (12, 112) along the surface direction of the sheet;
a plurality of second lower conductive pads (32) which are spaced apart from each other on the other surface of the lower insulation sheet (12, 112) along the surface direction of the sheet;
first lower conductive pins (42) which are attached respectively to each of the first lower conductive pads (22) such that one portion of each of the first lower conductive pins (42) protrudes below the lower insulation sheet (12, 112);
second lower conductive pins (52) which are attached respectively to each of the second lower conductive pads (32) such that one portion of each of the second lower conductive pins (52) protrudes below the lower insulation sheet (12, 112);
first conductive wires (71) which electrically connect the first upper conductive pads (21) and the first lower conductive pads (22) which correspond to each other such that the first upper conductive pins (41), the first upper conductive pads (21), the first lower conductive pads (22) and the first lower conductive pins (42) which correspond to each other form first conductive lines in the vertical direction; and
second conductive wires (72) which electrically connect the second upper conductive pads (31) and the second lower conductive pads (32) which correspond to each other such that the second upper conductive pins (51), the second upper conductive pads (31), the second lower conductive pads (32) and the second lower conductive pins (52) which correspond to each other form second conductive lines in the vertical direction.

7. The probe module (100) for Kelvin Test according to Claim 6,
wherein the upper insulation sheet (11, 111) and the lower insulation sheet (12, 112) are provided in the form of a PI film; and
wherein the first upper conductive pads (21), the second upper conductive pads (31), the first lower conductive pads (22) and the second lower conductive pads (32) are formed by patterning conductive layers of a flexible circuit substrate having the conductive layers respectively on both surfaces of the PI film.

8. The probe module (100) for Kelvin Test according to Claim 7,
wherein the first upper conductive pads (21), the second upper conductive pads (31), the first lower conductive pads (22) and the second lower conductive pads (32) are formed by plating base conductive layers which are formed after the conductive layers are patterned.

9. The probe module (100) for Kelvin Test according to Claim 6,
wherein the insulation elastic member (60, 160) is made of silicone material.

10. The probe module (100) for Kelvin Test according to Claim 6,
further comprising an insulation body (180) made of elastic material which surrounds the upper insulation sheet (11, 111), the lower insulation sheet (12, 112), the insulation elastic member (60, 160), the first upper conductive pads (21), the second upper conductive pads (31), the first lower conductive pads (22), the second lower conductive pads (32), 1 the first conductive wires (71) and the second conductive wires (72) in such a manner that the first upper conductive pins (41) and the second upper conductive pins (51) protrude upwardly and the first lower conductive pins (42) and the second lower conductive pins (52) protrude downwardly.

11. A method of manufacturing a probe module (100) for Kelvin Test comprising following steps:
(a) forming a plurality of first base conductive pads (321a) which are spaced apart from each other on one surface of an insulation sheet (310) made of flexible material along a surface of the sheet and each of which extends from an upper edge to a lower edge;
(b) forming a plurality of second base conductive pads (331a) which are spaced apart from each other on the other surface of the insulation sheet (310) along a surface of the sheet and each of which extends from an upper edge to a lower edge;
(c) attaching first upper conductive pins (41) respectively to an upper edge of each of the first base conductive pads (321a) such that one portion of each of the first upper conductive pins (41) protrudes above the insulation sheet (310);
(d) attaching second upper conductive pins (51) respectively to an upper edge of each of the second base conductive pads (331a) such that one portion of each of the second upper conductive pins (51) protrudes above the insulation sheet (310);
(e) attaching first lower conductive pins (42) respectively to a lower edge of each of the first base conductive pads (321a) such that one portion of each of the first lower conductive pins (42) protrudes below the insulation sheet (310);
(f) attaching second lower conductive pins (52) to a lower edge of each of the second base conductive pads (331a) such that one portion of each of the second lower conductive pins (52) protrudes below the insulation sheet (310);
(g) cutting off a boundary between the first upper conductive pins (41) and the first lower conductive pins (42) of the insulation sheet (310), the first base conductive pads (321a) and the second base conductive pads (331a) such that the insulation sheet (310) is divided into an upper insulation sheet (11, 111) and a lower insulation sheet (12, 112), the first base conductive pads (321a) are divided into first upper conductive pads (21) and first lower conductive pads (22), and the second base conductive pads (331a) are divided into second upper conductive pads (31) and second lower conductive pads (32);
(h) forming an insulation elastic member (60, 160) by connecting the first upper insulation sheet (11, 111) and the second lower insulation sheet (12, 112) with elastic and insulation material;
(i) connecting the first upper conductive pads (21) and the first lower conductive pads (22) which correspond to each other by each of first conductive wires (71); and
(j) connecting the second upper conductive pads (31) and the second lower conductive pads (32) which correspond to each other by each of second conductive wires (72).

12. The method according to Claim 11,
wherein the insulation sheet (310) is provided in the form of a PI film; and
wherein the first base conductive pad (321a) and the second base conductive pad (331a) are formed by patterning conductive layers of a flexible circuit substrate having conductive layers respectively on both surfaces of the PI film.

13. The method according to Claim 12,
wherein the first base conductive pad (321a) and the second base conductive pad (331a) are formed by plating base conductive layers which are formed after the conductive layers are patterned.

14. A method of manufacturing a probe module (100) for Kelvin Test comprising following steps:
(a) forming a plurality of first upper conductive pads (21) which are spaced apart from each other on an upper edge of one surface of an insulation sheet (310) made of flexible material along a surface of the sheet;
(b) forming a plurality of second upper conductive pads (31) which are spaced apart from each other on an upper edge of the other surface of the insulation sheet (310) along a surface of the sheet;
(c) forming a plurality of first lower conductive pads (22) which are spaced apart from each other on a lower edge of one surface of the insulation sheet (310) along a surface of the sheet;
(d) forming a plurality of second lower conductive pads (32) which are spaced apart from each other on a lower edge of the other surface of the insulation sheet (310) along a surface of the sheet;
(e) attaching first upper conductive pins (41) respectively to each of the first upper conductive pads (21) such that one portion of each of the first upper conductive pins (41) protrudes above the insulation sheet (310);
(f) attaching second upper conductive pins (51) respectively to each of the second upper conductive pads (31) such that one portion of each of the second upper conductive pins (51) protrudes above the insulation sheet (310);
(g) attaching first lower conductive pins (42) respectively to each of the first lower conductive pads (22) such that one portion of each of the first lower conductive pins (42) protrudes below the insulation sheet (310);
(h) attaching second lower conductive pins (52) respectively to each of the second lower conductive pads (32) such that one portion of each of the second lower conductive pins (52) protrudes below the insulation sheet (310);
(i) cutting off a boundary between the first upper conductive pins (41) and the first lower conductive pins (42) of the insulation sheet (310) such that the insulation sheet (310) is divided into an upper insulation sheet (11, 111) and a lower insulation sheet (12, 112);
(j) forming an insulation elastic member (60, 160) by connecting the upper insulation sheet (11, 111) and the lower insulation sheet (12, 112) with elastic and insulation material;
(k) connecting the first upper conductive pads (21) and the first lower conductive pads (22) which correspond to each other by each of first conductive wires (71); and
(l) connecting the second upper conductive pads (31) and the second lower conductive pads (32) which correspond to each other by each of second conductive wires (72).

15. The method according to Claim 14,
wherein the insulation sheet (310) is provided in the form of a PI film; and
wherein the first upper conductive pads (21), the second upper conductive pads (31), the first lower conductive pads (22) and the second lower conductive pads (32) are formed by patterning conductive layers of a flexible circuit substrate having conductive layers on both surfaces of the PI film.

## Patentansprüche

1. Sonde (10) für den Kelvin-Test bestehend aus:
eine obere Isolierfolie (11) aus flexiblem Material;
eine untere Isolierlage (12), die in vertikaler Richtung von der oberen Isolierlage (11) beabstandet ist und aus flexiblem Material besteht;
ein elastisches Isolierelement (60), das die obere Isolierplatte (11) und die untere Isolierplatte (12) verbindet und aus elastischem Material besteht;
ein erstes oberes leitendes Pad (21), das auf einer Oberfläche der oberen Isolierplatte (11) ausgebildet ist;
ein zweites oberes leitendes Pad (31), das auf der anderen Oberfläche der oberen Isolierplatte (11) ausgebildet ist;
einen ersten oberen leitfähigen Stift (41), der so an der ersten oberen leitfähigen Kontaktstelle (21) befestigt ist, dass ein Teil des ersten oberen leitfähigen Stifts (41) über die obere Isolierplatte (11) hinausragt;
einen zweiten oberen leitfähigen Stift (51), der so an der zweiten oberen leitfähigen Kontaktstelle (31) befestigt ist, dass ein Teil des zweiten oberen leitfähigen Stifts (51) über die obere Isolierplatte (11) hinausragt;
eine erste untere leitende Unterlage (22), die auf einer Oberfläche der unteren Isolierplatte (12) ausgebildet ist;
eine zweite untere leitende Unterlage (32), die auf der anderen Oberfläche der unteren Isolierplatte (12) ausgebildet ist;
einen ersten unteren leitfähigen Stift (42), der an der ersten unteren leitfähigen Kontaktstelle (22) so befestigt ist, dass ein Teil des ersten unteren leitfähigen Stifts (42) unter der unteren Isolierfolie (12) hervorsteht;
einen zweiten unteren leitfähigen Stift (52), der so an der zweiten unteren leitfähigen Fläche (32) befestigt ist, dass ein Teil des zweiten unteren leitfähigen Stifts (52) unter der unteren Isolierfolie (12) hervorsteht;
einen ersten leitfähigen Draht (71), der die erste obere leitfähige Kontaktstelle (21) und die erste untere leitfähige Kontaktstelle (22) elektrisch verbindet, so dass der erste obere leitfähige Stift (41), die erste obere leitfähige Kontaktstelle (21), die erste untere leitfähige Kontaktstelle (22) und der erste untere leitfähige Stift (42) eine erste leitfähige Linie in der vertikalen Richtung bilden; und
einen zweiten leitfähigen Draht (72), der die zweite obere leitfähige Kontaktstelle (31) und die zweite untere leitfähige Kontaktstelle (32) elektrisch verbindet, so dass der zweite obere leitfähige Stift (51), die zweite obere leitfähige Kontaktstelle (31), die zweite untere leitfähige Kontaktstelle (32) und der zweite untere leitfähige Stift (52) eine zweite leitfähige Linie in vertikaler Richtung bilden.

2. Sonde (10) für den Kelvin-Test nach Anspruch 1,
wobei die obere Isolierlage (11) und die untere Isolierlage (12) in Form eines PI-Films vorgesehen sind; und
wobei die erste obere leitende Kontaktstelle (21), die zweite obere leitende Kontaktstelle (31), die erste untere leitende Kontaktstelle (22) und die zweite untere leitende Kontaktstelle (32) durch Strukturieren von leitfähigen Schichten eines flexiblen Schaltungssubstrats mit den leitfähigen Schichten jeweils auf beiden Oberflächen des PI-Films gebildet werden.

3. Sonde (10) für den Kelvin-Test nach Anspruch 2,
wobei die erste obere leitende Kontaktstelle (21), die zweite obere leitende Kontaktstelle (31), die erste untere leitende Kontaktstelle (22) und die zweite untere leitende Kontaktstelle (32) durch Plattieren von leitfähigen Grundschichten gebildet werden, die nach dem Strukturieren der leitfähigen Schichten gebildet werden.

4. Sonde (10) für den Kelvin-Test nach Anspruch 1,
wobei das elastische Isolationselement (60) aus Silikonmaterial hergestellt ist.

5. Sonde (10) für den Kelvin-Test nach Anspruch 1,
ferner mit einem Isolierkörper (180) aus elastischem Material, der die obere Isolierplatte (11), die untere Isolierplatte (12), das elastische Isolierelement (60), die erste obere leitende Kontaktstelle (21), die zweite obere leitende Kontaktstelle (31), die erste untere leitende Kontaktstelle (22) umgibt, die zweite untere leitende Kontaktstelle (32), den ersten leitfähigen Draht (71) und den zweiten leitfähigen Draht (72) derart, dass der erste obere leitfähige Stift (41) und der zweite obere leitfähige Stift (51) nach oben vorstehen und der erste untere leitfähige Stift (42) und der zweite untere leitfähige Stift (52) nach unten vorstehen.

6. Ein Sondenmodul (100) für einen Kelvin-Test, bestehend aus:
eine obere Isolierfolie (11, 111) aus flexiblem Material;
eine untere Isolierlage (12, 112), die in vertikaler Richtung von der oberen Isolierlage (11, 111) beabstandet ist und aus flexiblem Material besteht;
ein elastisches Isolierelement (60, 160), das die obere Isolierplatte (11, 111) und die untere Isolierplatte (12, 112) verbindet und aus elastischem Material besteht;
eine Vielzahl von ersten oberen leitfähigen Pads (21), die auf einer Oberfläche der oberen Isolierplatte (11, 111) entlang der Oberflächenrichtung der Platte voneinander beabstandet sind;
eine Vielzahl von zweiten oberen leitfähigen Pads (31), die auf der anderen Oberfläche der oberen Isolierplatte (11, 111) entlang der Oberflächenrichtung der Platte voneinander beabstandet sind;
erste obere leitende Stifte (41), die jeweils an jedem der ersten oberen leitfähigen Pads (21) so befestigt sind, dass ein Teil jedes der ersten oberen leitfähigen Stifte (41) über die obere Isolierplatte (11, 111) hinausragt;
zweite obere leitende Stifte (51), die jeweils an jedem der zweiten oberen leitfähigen Pads (31) so befestigt sind, dass ein Teil jedes der zweiten oberen leitfähigen Stifte (51) über die obere Isolierplatte (11, 111) hinausragt;
eine Vielzahl von ersten unteren leitfähigen Pads (22), die auf einer Oberfläche der unteren Isolierplatte (12, 112) entlang der Oberflächenrichtung der Platte voneinander beabstandet sind;
eine Mehrzahl von zweiten unteren leitfähigen Pads (32), die auf der anderen Oberfläche der unteren Isolierplatte (12, 112) entlang der Oberflächenrichtung der Platte voneinander beabstandet sind;
erste untere leitende Stifte (42), die jeweils an jedem der ersten unteren leitfähigen Pads (22) so befestigt sind, dass ein Teil jedes der ersten unteren leitfähigen Stifte (42) unter die untere Isolierplatte (12, 112) vorsteht;
zweite untere leitende Stifte (52), die jeweils an jedem der zweiten unteren leitfähigen Pads (32) so befestigt sind, dass ein Teil jedes der zweiten unteren leitfähigen Stifte (52) unter die untere Isolierplatte (12, 112) vorsteht;
erste leitfähige Drähte (71), die die ersten oberen leitfähigen Pads (21) und die ersten unteren leitfähigen Pads (22), die einander entsprechen, elektrisch verbinden, so dass die ersten oberen leitfähigen Stifte (41), die ersten oberen leitfähigen Pads (21), die ersten unteren leitfähigen Pads (22) und die ersten unteren leitfähigen Stifte (42), die einander entsprechen, erste leitende Linien in vertikaler Richtung bilden; und
zweiten leitfähigen Draht (72), der die zweiten oberen leitfähigen Pads (31) und die zweiten unteren leitfähigen Pads (32), die einander entsprechen, elektrisch verbindet, so dass die zweiten oberen leitfähigen Stifte (51), die zweiten oberen leitfähigen Pads (31), die zweiten unteren leitfähigen Pads (32) und die zweiten unteren leitfähigen Stifte (52), die einander entsprechen, zweite leitfähige Linien in vertikaler Richtung bilden.

7. Sondenmodul (100) für den Kelvin-Test nach Anspruch 6,
wobei die obere Isolierlage (11, 111) und die untere Isolierlage (12, 112) in Form eines PI-Films vorgesehen sind; und
wobei die ersten oberen leitfähigen Pads (21), die zweiten oberen leitfähigen Pads (31), die ersten unteren leitfähigen Pads (22) und die zweiten unteren leitfähigen Pads (32) durch Strukturieren von leitfähigen Schichten eines flexiblen Schaltungssubstrats mit den leitfähigen Schichten jeweils auf beiden Oberflächen des PI-Films gebildet werden.

8. Sondenmodul (100) für den Kelvin-Test nach Anspruch 7,
wobei die ersten oberen leitfähigen Pads (21), die zweiten oberen leitfähigen Pads (31), die ersten unteren leitfähigen Pads (22) und die zweiten unteren leitfähigen Pads (32) durch Plattieren von leitfähigen Grundschichten gebildet werden, die nach dem Strukturieren der leitfähigen Schichten gebildet werden.

9. Sondenmodul (100) für den Kelvin-Test nach Anspruch 6,
wobei das elastische Isolationselement (60, 160) aus Silikonmaterial hergestellt ist.

10. Sondenmodul (100) für den Kelvin-Test nach Anspruch 6,
ferner mit einem aus elastischem Material hergestellten Isolierkörper (180), der die obere Isolierplatte (11, 111), die untere Isolierplatte (12, 112), das elastische Isolierelement (60, 160), die ersten oberen leitfähigen Pads (21), die zweiten oberen leitfähigen Pads (31), die ersten unteren leitfähigen Pads (22) umgibt, die zweiten unteren leitfähigen Pads (32), die ersten leitfähigen Drähte (71) und die zweiten leitfähigen Drähte (72) in einer solchen Weise, dass die ersten oberen leitfähigen Stifte (41) und die zweiten oberen leitfähigen Stifte (51) nach oben vorstehen und die ersten unteren leitfähigen Stifte (42) und die zweiten unteren leitfähigen Stifte (52) nach unten vorstehen.

11. Verfahren zur Herstellung eines Sondenmoduls (100) für einen Kelvin-Test, das die folgenden Schritte umfasst:
(a) Bilden einer Vielzahl von ersten Basis-Leiterflächen (321a), die auf einer Oberfläche einer aus flexiblem Material hergestellten Isolierfolie (310) entlang einer Oberfläche der Folie voneinander beabstandet sind und von denen sich jede von einem oberen Rand zu einem unteren Rand erstreckt;
(b) Bilden einer Vielzahl von zweiten leitfähigen Basis-Leiterpads (331a), die auf der anderen Oberfläche der Isolierplatte (310) entlang einer Oberfläche der Platte voneinander beabstandet sind und von denen sich jede von einem oberen Rand zu einem unteren Rand erstreckt;
(c) Anbringen erster oberer leitfähiger Stifte (41) jeweils an einer Oberkante jeder der ersten leitfähigen Basis-Leiterpads (321a), so dass ein Teil jedes der ersten oberen leitfähigen Stifte (41) über die Isolierplatte (310) hinausragt;
(d) Anbringen zweiter oberer leitfähiger Stifte (51) jeweils an einer Oberkante jeder der zweiten leitfähigen Basis-Leiterpads (331a), so dass ein Teil jedes der zweiten oberen leitfähigen Stifte (51) über die Isolationsfolie (8310) hinausragt);
(e) Anbringen erster unterer leitfähiger Stifte (42) jeweils an einer Unterkante jeder der ersten leitfähigen Basis-Pads (321a), so dass ein Teil jedes der ersten unteren leitfähigen Stifte (42) unter die Isolationsfolie (310) vorsteht;
(f) Anbringen zweiter unterer leitfähiger Stifte (52) an einer Unterkante jeder der zweiten leitfähigen Basis-Pads (331a), so dass ein Teil jedes der zweiten unteren leitfähigen Stifte (52) unter der Isolierfolie (310) hervorsteht;
(g) Abschneiden einer Grenze zwischen den ersten oberen Leiterstiften (41) und den ersten unteren Leiterstiften (42) der Isolierplatte (310), den ersten Basis-Leiterpads (321a) und den zweiten Basis-Leiterpads (331a), so dass die Isolierplatte (310) in eine obere Isolierplatte (11) geteilt wird, 111) und einer unteren Isolationsfolie (12, 112), wobei die ersten Basis-Leiterpads (321a) in erste obere Leiterpads (21) und erste untere Leiterpads (22) unterteilt sind und die zweiten Basis-Leiterpads (331a) in zweite obere Leiterpads (31) und zweite untere Leiterpads (32) unterteilt sind;
(h) Bilden eines elastischen Isolationselements (60) durch Verbinden der ersten oberen Isolationsbahn (11, 111) und der zweiten unteren Isolationsbahn (12, 112) mit elastischem und isolierendem Material;
(i) Verbinden der ersten oberen leitfähigen Flächen (21) und der ersten unteren leitfähigen Flächen (22), die einander entsprechen, durch jeden der ersten leitfähigen Drähte (71); und
(j) Verbinden der zweiten oberen leitfähigen Pads (31) und der zweiten unteren leitfähigen Pads (32), die einander entsprechen, durch jeden der zweiten leitfähigen Drähte (72).

12. Verfahren nach Anspruch 11,
wobei die Isolierschicht (310) in Form eines PI-Films vorgesehen ist; und
wobei das erste leitende Basis-Leiterpad (321a) und das zweite leitende Basis-Leiterpad (331a) durch Strukturieren von leitfähigen Schichten eines flexiblen Schaltungssubstrats mit leitfähigen Schichten jeweils auf beiden Oberflächen des PI-Films gebildet werden.

13. Verfahren nach Anspruch 12,
wobei das erste leitende Basis-Leiterpad (321a) und das zweite leitende Basis-Leiterpads (331a) durch Plattieren von leitfähigen Basisschichten gebildet werden, die nach dem Strukturieren der leitfähigen Schichten gebildet werden.

14. Verfahren zur Herstellung eines Sondenmoduls (100) für einen Kelvin-Test, das die folgenden Schritte umfasst:
(a) Bilden einer Vielzahl erster oberer leitfähiger Pads (21), die voneinander an einem oberen Rand einer Oberfläche einer Isolierfolie (310) aus flexiblem Material entlang einer Oberfläche der Folie beabstandet sind;
(b) Bilden einer Vielzahl von zweiten oberen leitfähigen Pads (31), die voneinander an einem oberen Rand der anderen Oberfläche der Isolierplatte (310) entlang einer Oberfläche der Platte beabstandet sind;
(c) Bilden einer Vielzahl von ersten unteren leitfähigen Pads (22), die an einem unteren Rand einer Oberfläche der Isolierplatte (310) entlang einer Oberfläche der Platte voneinander beabstandet sind;
(d) Bilden einer Vielzahl von zweiten unteren leitfähigen Pads (32), die voneinander an einem unteren Rand der anderen Oberfläche der Isolierplatte (310) entlang einer Oberfläche der Platte beabstandet sind;
(e) Anbringen erster oberer leitfähiger Stifte (41) jeweils an jeder der ersten oberen leitfähigen Flächen (21), so dass ein Teil jedes der ersten oberen leitfähigen Stifte (41) über die Isolationsfolie (310) hinausragt;
(f) Anbringen zweiter oberer leitfähiger Stifte (51) jeweils an jeder der zweiten oberen leitfähigen Pads (31), so dass ein Teil jedes der zweiten oberen leitfähigen Stifte (51) über die Isolationsfolie (310) hinausragt;
(g) Anbringen erster unterer leitfähiger Stifte (42) jeweils an jeder der ersten unteren leitfähigen Flächen (22), so dass ein Teil jedes der ersten unteren leitfähigen Stifte (42) unter die Isolationsfolie (310) vorsteht;
(h) Anbringen zweiter unterer leitfähiger Stifte (52) jeweils an jeder der zweiten unteren leitfähigen Pads (32), so dass ein Teil jedes der zweiten unteren leitfähigen Stifte (52) unter der Isolierfolie (310) hervorsteht;
(i) Abschneiden einer Grenze zwischen den ersten oberen Leiterstiften (41) und den ersten unteren Leiterstiften (42) der Isolierplatte, so dass die Isolierplatte in eine obere Isolierplatte (11, 111) und eine untere Isolierplatte (12, 112) geteilt wird;
(j) Bilden eines elastischen Isolationselements (60, 160) durch Verbinden der oberen Isolationsbahn (11, 111) und der unteren Isolationsbahn (12, 112) mit elastischem und isolierendem Material;
(k) Verbinden der ersten oberen leitfähigen Flächen (21) und der ersten unteren leitfähigen Flächen (22), die einander entsprechen, durch jeden der ersten leitfähigen Drähte (71); und
(l) Verbinden der zweiten oberen leitfähigen Pads (31) und der zweiten unteren leitfähigen Pads (32), die einander entsprechen, durch jeden der zweiten leitfähigen Drähte (72).

15. Verfahren nach Anspruch 14,
wobei die Isolierschicht (310) in Form eines PI-Films ausgebildet ist; und
wobei die ersten oberen leitfähigen Pads (21), die zweiten oberen leitfähigen Pads (31), die ersten unteren leitfähigen Pads (22) und die zweiten unteren leitfähigen Pads (32) durch Strukturieren von leitfähigen Schichten eines flexiblen Schaltungssubstrats mit leitfähigen Schichten auf beiden Oberflächen des PI-Films gebildet werden.

## Revendications

1. Sonde (10) pour test de Kelvin comprenant :
une feuille isolante supérieure (11) réalisée dans un matériau souple ;
une feuille isolante inférieure (12)
qui est espacée de la feuille isolante supérieure (11) dans le sens vertical et qui est réalisée dans un matériau souple ;
un élément élastique isolant (60)
qui connecte la feuille isolante supérieure (11) et la feuille isolante inférieure (12) et qui est réalisé dans un matériau élastique ;
un premier plot conducteur supérieur (21)
qui est formé sur une surface de la feuille isolante supérieure (11) ;
un second plot conducteur supérieur (31)
qui est formé sur l'autre surface de la feuille isolante supérieure (11) ;
une première broche conductrice supérieure (41)
qui est fixée au premier plot conducteur supérieur (21) de telle sorte qu'une partie de la première broche conductrice supérieure (41) dépasse au-dessus de la feuille isolante supérieure (11) ;
une seconde broche conductrice supérieure (51)
qui est fixée au second plot conducteur supérieur (31) de telle sorte qu'une partie de la seconde broche conductrice supérieure (51) dépasse au-dessus de la feuille isolante supérieure (11) ;
un premier plot conducteur inférieur (22)
qui est formé sur une surface de la feuille isolante inférieure (12) ;
un second plot conducteur inférieur (32)
qui est formé sur l'autre surface de la feuille isolante inférieure (12) ;
une première broche conductrice inférieure (42)
qui est fixée au premier plot conducteur inférieur (22) de telle sorte qu'une partie de la première broche conductrice inférieure (42) dépasse en dessous de la feuille isolante inférieure (12) ;
une seconde broche conductrice inférieure (52)
qui est fixée au second plot conducteur inférieur (32) de telle sorte qu'une partie de la seconde broche conductrice inférieure (52) dépasse en dessous de la feuille isolante inférieure (12) ;
un premier fil conducteur (71)
qui connecte électriquement le premier plot conducteur supérieur (21) et le premier plot conducteur inférieur (22) de telle sorte que la première broche conductrice supérieure (41), le premier plot conducteur supérieur (21), le premier plot conducteur inférieur (22) et la première broche conductrice inférieure (42) forment une première ligne conductrice dans le sens vertical ; et
un second fil conducteur (72)
qui connecte électriquement le second plot conducteur supérieur (31) et le second plot conducteur inférieur (32) de telle sorte que la seconde broche conductrice supérieure (51), le second plot conducteur supérieur (31), le second plot conducteur inférieur (32) et la seconde broche conductrice inférieure (52) forment une seconde ligne conductrice dans le sens vertical.

2. Sonde (10) pour test de Kelvin selon la revendication 1,
dans laquelle la feuille isolante supérieure (11) et la feuille isolante inférieure (12) sont fournies sous forme de film de PI ; et
dans laquelle le premier plot conducteur supérieur (21), le second plot conducteur supérieur (31), le premier plot conducteur inférieur (22) et le second plot conducteur inférieur (32) sont formés en structurant des couches conductrices d'un substrat de circuit souple présentant les couches conductrices respectivement sur les deux surfaces du film de PI.

3. Sonde (10) pour test de Kelvin selon la revendication 2,
dans laquelle le premier plot conducteur supérieur (21), le second plot conducteur supérieur (31), le premier plot conducteur inférieur (22) et le second plot conducteur inférieur (32) sont formés en plaquant des couches conductrices de base qui sont formées après la structuration des couches conductrices.

4. Sonde (10) pour test de Kelvin selon la revendication 1,
dans laquelle l'élément élastique isolant (60) est réalisé dans un matériau de silicone.

5. Sonde (10) pour test de Kelvin selon la revendication 1,
comprenant en outre un corps isolant (180) réalisé dans un matériau élastique qui entoure la feuille isolante supérieure (11), la feuille isolante inférieure (12), l'élément élastique isolant (60), le premier plot conducteur supérieur (21), le second plot conducteur supérieur (31), le premier plot conducteur inférieur (22), le second plot conducteur inférieur (32), le premier fil conducteur (71) et le second fil conducteur (72) de manière à ce que la première broche conductrice supérieure (41) et la seconde broche conductrice supérieure (51) dépassent vers le haut et la première broche conductrice inférieure (42) et la seconde broche conductrice inférieure (52) dépassent vers le bas.

6. Module sonde (100) pour test de Kelvin comprenant :
une feuille isolante supérieure (11, 111) réalisée dans un matériau souple ;
une feuille isolante inférieure (12, 112)
qui est espacée de la feuille isolante supérieure (11, 111) dans le sens vertical et qui est réalisée dans un matériau souple ;
un élément élastique isolant (60, 160)
qui connecte la feuille isolante supérieure (11, 111) et la feuille isolante inférieure (12, 112) et qui est réalisé dans un matériau élastique ;
une pluralité de premiers plots conducteurs supérieurs (21)
qui sont espacés les uns des autres sur une surface de la feuille isolante supérieure (11, 111) le long de la surface de la feuille ;
une pluralité de seconds plots conducteurs supérieurs (31)
qui sont espacés les uns des autres sur l'autre surface de la feuille isolante supérieure (11, 111) le long de la surface de la feuille ;
des premières broches conductrices supérieures (41)
qui sont fixées respectivement à chacun des premiers plots conducteurs supérieurs (21) de telle sorte qu'une partie de chacune des premières broches conductrices supérieures (41) dépasse au-dessus de la feuille isolante supérieure (11, 111) ;
des secondes broches conductrices supérieures (51)
qui sont fixées respectivement à chacun des seconds plots conducteurs supérieurs (31) de telle sorte qu'une partie de chacune des secondes broches conductrices supérieures (51) dépasse au-dessus de la feuille isolante supérieure (11, 111) ;
une pluralité de premiers plots conducteurs inférieurs (22)
qui sont espacés les uns des autres sur une surface de la feuille isolante inférieure (12, 112) le long de la surface de la feuille ;
une pluralité de seconds plots conducteurs inférieurs (32)
qui sont espacés les uns des autres sur l'autre surface de la feuille isolante inférieure (12, 112) le long de la surface de la feuille ;
des premières broches conductrices inférieures (42)
qui sont fixées respectivement à chacun des premiers plots conducteurs inférieurs (22) de telle sorte qu'une partie de chacune des premières broches conductrices inférieures (42) dépasse en dessous de la feuille isolante inférieure (12, 112) ;
des secondes broches conductrices inférieures (52)
qui sont fixées respectivement à chacun des seconds plots conducteurs inférieurs (32) de telle sorte qu'une partie de chacune des secondes broches conductrices inférieures (52) dépasse en dessous de la feuille isolante inférieure (12, 112) ;
des premiers fils conducteurs (71)
qui connectent électriquement les premiers plots conducteurs supérieurs (21) et les premiers plots conducteurs inférieurs (22) qui correspondent les uns aux autres de telle sorte que les premières broches conductrices supérieures (41), les premiers plots conducteurs supérieurs (21), les premiers plots conducteurs inférieurs (22) et les premières broches conductrices inférieures (42) qui correspondent les uns aux autres forment des premières lignes conductrices dans le sens vertical ; et
des seconds fils conducteurs (72)
qui connectent électriquement les seconds plots conducteurs supérieurs (31) et les seconds plots conducteurs inférieurs (32) qui correspondent les uns aux autres de telle sorte que les secondes broches conductrices supérieures (51), les seconds plots conducteurs supérieurs (31), les seconds plots conducteurs inférieurs (32) et les secondes broches conductrices inférieures (52) qui correspondent les uns aux autres forment des secondes lignes conductrices dans le sens vertical.

7. Module sonde (100) pour test de Kelvin selon la revendication 6,
dans lequel la feuille isolante supérieure (11, 111) et la feuille isolante inférieure (12, 112) sont fournies sous forme de film de PI ; et
dans lequel les premiers plots conducteurs supérieurs (21), les seconds plots conducteurs supérieurs (31), les premiers plots conducteurs inférieurs (22) et les seconds plots conducteurs inférieurs (32) sont formés en structurant des couches conductrices d'un substrat de circuit souple présentant les couches conductrices respectivement sur les deux surfaces du film de PI.

8. Module sonde (100) pour test de Kelvin selon la revendication 7,
dans lequel les premiers plots conducteurs supérieurs (21), les seconds plots conducteurs supérieurs (31), les premiers plots conducteurs inférieurs (22) et les seconds plots conducteurs inférieurs (32) sont formés en plaquant des couches conductrices de base qui sont formées après la structuration des couches conductrices.

9. Module sonde (100) pour test de Kelvin selon la revendication 6,
dans lequel l'élément élastique isolant (60, 160) est réalisé dans un matériau de silicone.

10. Module sonde (100) pour test de Kelvin selon la revendication 6,
comprenant en outre un corps isolant (180) réalisé dans un matériau élastique qui entoure la feuille isolante supérieure (11, 111), la feuille isolante inférieure (12, 112), l'élément élastique isolant (60, 160), les premiers plots conducteurs supérieurs (21), les seconds plots conducteurs supérieurs (31), les premiers plots conducteurs inférieurs (22), les seconds plots conducteurs inférieurs (32), les premiers fils conducteurs (71) et les seconds fils conducteurs (72) de manière à ce que les premières broches conductrices supérieures (41) et les secondes broches conductrices supérieures (51) dépassent vers le haut et les premières broches conductrices inférieures (42) et les secondes broches conductrices inférieures (52) dépassent vers le bas.

11. Procédé de fabrication d'un module sonde (100) pour test de Kelvin comprenant les étapes suivantes :
(a) la formation d'une pluralité de premiers plots conducteurs de base (321a) qui sont espacés les uns des autres sur une surface d'une feuille isolante (310) réalisée dans un matériau souple le long d'une surface de la feuille et qui s'étendent chacun d'un bord supérieur à un bord inférieur ;
(b) la formation d'une pluralité de seconds plots conducteurs de base (331a) qui sont espacés les uns des autres sur l'autre surface de la feuille isolante (310) le long d'une surface de la feuille et qui s'étendent chacun d'un bord supérieur à un bord inférieur ;
(c) la fixation de premières broches conductrices supérieures (41) respectivement sur un bord supérieur de chacun des premiers plots conducteurs de base (321a) de telle sorte qu'une partie de chacune des premières broches conductrices supérieures (41) dépasse au-dessus de la feuille isolante (310);
(d) la fixation de secondes broches conductrices supérieures (51) respectivement sur un bord supérieur de chacun des seconds plots conducteurs de base (331a) de telle sorte qu'une partie de chacune des secondes broches conductrices supérieures (51) dépasse au-dessus de la feuille isolante (310);
(e) la fixation de premières broches conductrices inférieures (42) respectivement sur un bord inférieur de chacun des premiers plots conducteurs de base (321a) de telle sorte qu'une partie de chacune des premières broches conductrices inférieures (42) dépasse en dessous de la feuille isolante (310);
(f) la fixation de secondes broches conductrices inférieures (52) sur un bord inférieur de chacun des seconds plots conducteurs de base (331a) de telle sorte qu'une partie de chacune des secondes broches conductrices inférieures (52) dépasse en dessous de la feuille isolante (310) ;
(g) la découpe d'une frontière entre les premières broches conductrices supérieures (41) et les premières broches conductrices inférieures (42) de la feuille isolante (310), les premiers plots conducteurs de base (321a), et les seconds plots conducteurs de base (331a) de telle sorte que la feuille isolante (310) soit divisée en une feuille isolante supérieure (11, 111) et une feuille isolante inférieure (12, 112),
les premiers plots conducteurs de base (321a) soient divisés en premiers plots conducteurs supérieurs (21) et premiers plots conducteurs inférieurs (22), et
les seconds plots conducteurs de base (331a) soient divisés en seconds plots conducteurs supérieurs (31) et seconds plots conducteurs inférieurs (32) ;
(h) la formation d'un élément élastique isolant (60, 160) par la connexion de la première feuille isolante supérieure (11, 111) et de la seconde feuille isolante inférieure (12, 112) avec un matériau élastique et isolant ;
(i) la connexion des premiers plots conducteurs supérieurs (21) et des premiers plots conducteurs inférieurs (22) qui correspondent les uns aux autres par chacun de premiers fils conducteurs (71) ; et
(j) la connexion des seconds plots conducteurs supérieurs (31) et des seconds plots conducteurs inférieurs (32) qui correspondent les uns aux autres par chacun de seconds fils conducteurs (72).

12. Procédé selon la revendication 11,
dans lequel la feuille isolante (310) est fournie sous forme de film de PI ; et
dans lequel le premier plot conducteur de base (321a) et le second plot conducteur de base (331a) sont formés en structurant des couches conductrices d'un substrat de circuit souple présentant des couches conductrices respectivement sur les deux surfaces du film de PI.

13. Procédé selon la revendication 12,
dans lequel le premier plot conducteur de base (321a) et le second plot conducteur de base (331a) sont formés en plaquant des couches conductrices de base qui sont formées après la structuration des couches conductrices.

14. Procédé de fabrication d'un module sonde (100) pour test de Kelvin comprenant les étapes suivantes :
(a) la formation d'une pluralité de premiers plots conducteurs supérieurs (21) qui sont espacés les uns des autres sur un bord supérieur d'une surface d'une feuille isolante (310) réalisée dans un matériau souple le long d'une surface de la feuille ;
(b) la formation d'une pluralité de seconds plots conducteurs supérieurs (31) qui sont espacés les uns des autres sur un bord supérieur de l'autre surface de la feuille isolante (310) le long d'une surface de la feuille ;
(c) la formation d'une pluralité de premiers plots conducteurs inférieurs (22) qui sont espacés les uns des autres sur un bord inférieur d'une surface de la feuille isolante (310) le long d'une surface de la feuille ;
(d) la formation d'une pluralité de seconds plots conducteurs inférieurs (32) qui sont espacés les uns des autres sur un bord inférieur de l'autre surface de la feuille isolante (310) le long d'une surface de la feuille ;
(e) la fixation de premières broches conductrices supérieures (41) respectivement à chacun des premiers plots conducteurs supérieurs (21) de telle sorte qu'une partie de chacune des premières broches conductrices supérieures (41) dépasse au-dessus de la feuille isolante (310) ;
(f) la fixation de secondes broches conductrices supérieures (51) respectivement à chacun des seconds plots conducteurs supérieurs (31) de telle sorte qu'une partie de chacune des secondes broches conductrices supérieures (51) dépasse au-dessus de la feuille isolante (310) ;
(g) la fixation de premières broches conductrices inférieures (42) respectivement à chacun des premiers plots conducteurs inférieurs (22) de telle sorte qu'une partie de chacune des premières broches conductrices inférieures (42) dépasse en dessous de la feuille isolante (310) ;
(h) la fixation de secondes broches conductrices inférieures (52) respectivement à chacun des seconds plots conducteurs inférieurs (32) de telle sorte qu'une partie de chacune des secondes broches conductrices inférieures (52) dépasse en dessous de la feuille isolante (310) ;
(i) la découpe d'une frontière entre les premières broches conductrices supérieures (41) et les premières broches conductrices inférieures (42) de la feuille isolante (310) de telle sorte que la feuille isolante (310) soit divisée en une feuille isolante supérieure (11, 111) et une feuille isolante inférieure (12, 112) ;
(j) la formation d'un élément élastique isolant (60, 160) par la connexion de la feuille isolante supérieure (11, 111) et de la feuille isolante inférieure (12, 112) avec un matériau élastique et isolant ;
(k) la connexion des premiers plots conducteurs supérieurs (21) et des premiers plots conducteurs inférieurs (22) qui correspondent les uns aux autres par chacun de premiers fils conducteurs (71) ; et
(l) la connexion des seconds plots conducteurs supérieurs (31) et des seconds plots conducteurs inférieurs (32) qui correspondent les uns aux autres par chacun de seconds fils conducteurs (72).

15. Procédé selon la revendication 14,
dans lequel la feuille isolante (310) est fournie sous forme de film de PI ; et
dans lequel les premiers plots conducteurs supérieurs (21), les seconds plots conducteurs supérieurs (31), les premiers plots conducteurs inférieurs (22) et les seconds plots conducteurs inférieurs (32) sont formés en structurant des couches conductrices d'un substrat de circuit souple présentant des couches conductrices sur les deux surfaces du film de PI.
